(19) **Europäisches Patentamt / European Patent Office / Office européen des brevets**

(11) **EP 1 750 271 B1**

(12) **EUROPEAN PATENT SPECIFICATION**

(45) Date of publication and mention
of the grant of the patent:
**11.05.2011 Bulletin 2011/19**

(51) Int Cl.:
*G11C 5/14* (2006.01)　　　*G11C 16/30* (2006.01)

(21) Application number: **05425558.3**

(22) Date of filing: **28.07.2005**

(54) **Multistage regulator for charge-pump boosted voltage applications**

Mehrstufenregler für Ladungspumpen in Spannungserhöhungsanwendungen

Régulateur à étages multiples pour un circuit de pompe de charge dans des applications de tension d'alimentation

(84) Designated Contracting States:
**DE FR GB IT**

(43) Date of publication of application:
**07.02.2007 Bulletin 2007/06**

(73) Proprietors:
- **STMicroelectronics Srl
  20041 Agrate Brianza (MB) (IT)**
- **Hynix Semiconductor Inc.
  Kyoungki-do (KR)**

(72) Inventors:
- **Crippa, Luca
  20040 Busnago (IT)**
- **Sangalli, Miriam
  20061 Carugate (IT)**
- **Ragone, Giancarlo
  89047 Roccella Jonica (IT)**
- **Micheloni, Rino
  22078 Turate (IT)**

(74) Representative: **Kraus, Jürgen Helmut et al
Leinweber & Zimmermann
Rosental 7
80331 München (DE)**

(56) References cited:
US-A- 5 936 388　　　US-A1- 2002 118 568
US-B1- 6 347 029

**Description**

BACKGROUND

Field of the Invention

The present invention relates to integrated circuits that include charge-pump voltage boosting circuits and in particular to a multistage circuit for regulating a boosted voltage generated by a charge-pump voltage multiplier circuit or for regulating the discharging of a capacitance that may be charged at a boosted voltage.

Discussion of prior art

Whenever certain circuits of an integrated device require a supply, control or biasing voltages higher than the power supply voltage of the integrated device, it is a general practice of integrating dedicated charge-pump voltage multipliers for generating a boosted voltage of the required level.

Often the boosted voltage generated by a common charge-pump circuit needs to be regulated for ensuring a correct bias (a boosted voltage that remains within a specified range notwithstanding the current absorbed by the biased load or circuit) and in these cases, a dedicated circuit for regulating the voltage on an output node of the regulator to which the circuit or load to be powered, biased or controlled, that may generally be equated to a capacitive load, is connected. Similarly, a capacitance that eventually may be charged at a high voltage, e.g. at a charge-pump boosted voltage, may need to be discharged in a controlled manner, in other words with a certain discharge circuit and also in this case a dedicated regulating circuit must be integrated.

An important example of an integrated device with these requirements is a nonvolatile memory device that commonly requires biasing voltage levels higher than the power supply voltage of the device during program/erase phases of operation. For example, in a state-of-the-art multilevel flash memory device of NAND type, program/erase operations may require boosted voltages starting from around 10V and up to about 20-22V.

Indeed, in one-bit/cell flash memories, such a dedicated voltage regulator may be omitted and the output voltage of the charge-pump circuit be employed directly, without any regulation, by relaying solely on the ON-OFF control of the charge-pump circuit that generates the boosted voltage. As a matter of fact, in state-of-the-art one-bit/cell flash memories, a ripple of about 1V to 3V on the boosted voltage output by the ON-OFF controlled charge-pump circuit is generally tolerable.

By contrast, in so-called "multilevel" memory devices, where more bits can be stored in each single cell of the memory array, the much higher precision that is required for the biasing voltages makes indispensable to integrate a dedicated boosted voltage regulator in order to reduce the amplitude of the ripple on the output biasing voltages that are required during different phases of operation of the memory.

Of course, similar requisites of precision of the output boosted voltages are encountered also in other integrated devices, in which cases the same requirement of integrating a dedicated regulating circuit of the boosted voltages generated by the charge-pump circuit arises.

On a different account, fabrication technologies of integrated devices strive to contain costs. This cost awareness of chip manufacturing, specially for devices designed for mass production (destined primarily to consumer markets) imposes, to exploit every technological advance in silicon processing to reduce the number and criticity of processing steps and the number of masks required, in order to produce devices at the lowest price per unit as possible.

Again an important example of this category of integrated device are nonvolatile memories, the fabrication technology of which is so streamlined for reducing costs that does not generally permit to form along to normal low voltage (LV) CMOS structures also special high voltage (HV) structures (transistors capable of withstanding a relatively high voltage), unless additional processing steps and relative masks are introduced for realizing the "high side" transistor of the CMOS structure that for common devices, for example a NAND type flash memory, generally supplied with positive voltages, both for the normal power supply voltage and for charge-pump boosted voltages, is the PMOS transistor. As a matter of fact, the "low side" transistor, generally the NMOS transistor may be realized with an appropriate H.V. structure , where needed, without significative (in terms of costs) changes of the fabrication process

As it is well known to a skilled person, according to the most common fabrication processes of these types of integrated devices, the PMOS transistor of the CMOS pair (PMOS + NMOS) is the critical structure that does not admit voltage differences among its terminals (source, drain, gate and bulk) above about 4 to 5V).

When a positive boosted voltage regulating circuit to be supplied at an unregulated charge-pump boosted voltage in the range of 20-24V is required, for example for fabricating a multilevel nonvolatile flash memory, the normal low voltage PMOS transistor structure of the voltage regulator that is realized with the processing steps of any low cost one bit/cell flash memory fabrication process may often be intrinsically unsuitable and therefore additional costs of modifying the normal process introducing additional dedicated masks for realizing a high voltage PMOS structure cannot be avoided.

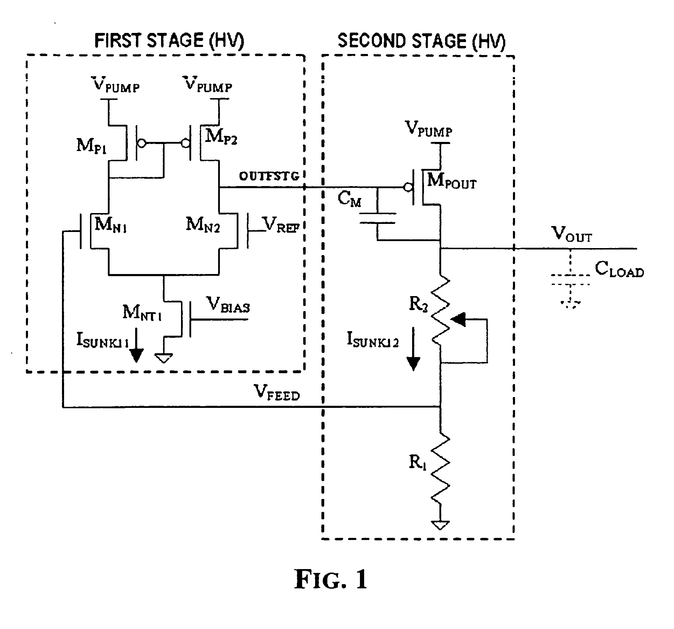

For illustrating the problem, **Figure 1** shows a typical multistage circuit powered at an unregulated charge-pump boosted voltage $V_{PUMP}$ for regulating the voltage $V_{OUT}$.

In the example shown, the first stage is a differential stage, to a first input of which is coupled a reference (control) voltage $V_{REF}$ and to a second input of which a scaled replica $V_{FEED}$ of the output voltage $V_{OUT}$ is fed back. The output stage is a PMOS transistor $M_{POUT}$ that necessarily must have a high voltage structure in order to withstand the relatively high level of $V_{PUMP}$ (the unregulated charge-pump output voltage).

It is evident the need of a less expensive alternative solution to the practice of integrating high voltage PMOS structures specifically for implementing the required regulating circuits of a charge-pump generated boosted voltage and of the discharge current of a capacitance charged at the boosted voltage.

In fact, as already mentioned, a similar problem of handling a charge-pump boosted voltage without integrating transistor structures of conductivity type equal to the sign of the boosted voltage with special high voltage characteristics, arises when a capacitance that is eventually charged at a boosted voltage needs to be discharged with a current regulated by a dedicated regulating circuit.

US 2002/118568 discloses a voltage regulator for outputting a regulated voltage that has a first stage including two operational amplifiers, and a second stage, powered with a boosted voltage, that includes two high voltage transistors, controlled by a respective operational amplifier of the first stage, coupled together through a current mirror realized with high voltage transistors.

US-B1-6,347,029 discloses a current protection circuit for linear voltage regulators that meets the Universal Serial Bus (USB) specification for USB load devices, and a current protection circuit for linear voltage regulators that causes the regulator to provide a fold back current upon detecting certain conditions.

<u>SUMMARY OF THE INVENTION</u>

This cost saving objective is accomplished by the present invention by providing a multistage circuit for regulating the charge voltage or the discharge current of a capacitance of an integrated device at a certain charge-pump generated boosted voltage that can be safely implemented without obliging to integrate high voltage transistor structures of p-type or of N-type corresponding to the sign of the boosted voltage (high-side transistors).

Another fulfilled objective is to provide a multilevel nonvolatile flash memory device comprising a boosted voltage regulator that can be entirely fabricated with a low cost nonvolatile flash memory fabrication process.

Basically, the novel multistage circuit for regulating the charge voltage or the discharge current of a capacitance in an integrated device comprising at least a first stage and a second stage in cascade to the first stage and coupled to the capacitance, has the first stage supplied at an unboosted power supply voltage of the integrated device and the second stage supplied at an unregulated charge-pump generated boosted voltage and is composed of a transistor of P-type or of N-type depending on whether the sign of said boosted voltage and of the power supply voltage is negative or positive, respectively.

The drain of the output stage transistor is coupled to the boosted voltage either through a resistive pull-up or a voltage limiter.

The multistage circuit additionally comprises an output follower stage coupled to the second stage, said output follower stage including another high voltage transistor to charge the capacitance of the integrated circuit device. The connections between the elements are specified in the characterizing part of claim 1.

The invention is defined in the annexed claims.

<u>BRIEF DESCRIPTION OF THE DRAWINGS</u>

<u>Figure 1</u> depicts, as already discussed, a typical multistage voltage regulator of a charge-pump boosted voltage to be applied on a capacitance.

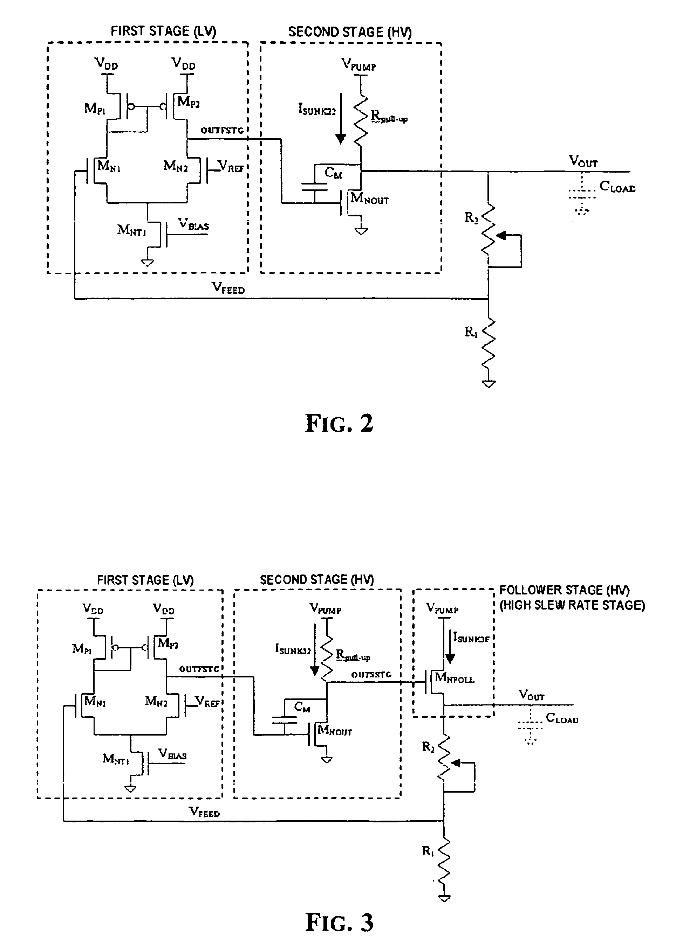

<u>Figure 2</u> shows a multistage voltage regulator functionally comparable to the known voltage regulator of Figure 1,

<u>Figure 3</u> shows a first embodiment of the invention including an output follower stage acting as an output current buffer, based on the multistage voltage regulator of Figure 2.

A viable alternative to the known voltage regulator of Figure 1, without requiring the formation of any high voltage CMOS structure, is depicted in Figure 2.

As shown, the first stage, $M_{P1}$, $M_{P2}$, $M_{N1}$, $M_{N2}$, $M_{NT1}$, is a common differential stage, FIRST STAGE (LV), that is powered at normal (unboosted) power supply voltage $V_{DD}$, while the second stage, SECOND STAGE (HV), is supplied at the unregulated charge-pump generated boosted voltage $V_{PUMP}$.

By powering the first stage, FIRST STAGE (LV), at $V_{DD}$, PMOS transistors of normal low voltage (LV) structure, $M_{P1}$ and $M_{P2}$, may be used for the load current mirror of the two branches of the differential stage.

The second stage SECOND STAGE (HV), is implemented by using a HV NMOS transistor $M_{NOUT}$ with a resistive pull-up, $R_{PULL-UP}$, connection to the boosted voltage node $V_{PUMP}$, that is to the output node of a charge-pump voltage multiplier (not shown in the figures) that generates the required boosted voltage $V_{PUMP}$.

In case of a relatively heavy capacitive load, $C_{LOAD}$, to be driven, the basic multistage voltage regulator circuit of Figure 2 may have an excessive consumption.

In fact, assuming that the total capacitive load, $C_{LOAD}$, be of about 100 pF, the time needed for charging the parasitic capacitance would be in the order of three to five times $T_{rise}$, depending of the value of the output voltage to be produced on the capacitive load, wherein:

$$T_{rise} = C_{LOAD} \bullet R_{PULL-UP} \qquad (1)$$

If such a 100pF capacitance must be completely charged at a certain programmed boosted voltage, $V_{OUT}$, in 1 $\mu$s time interval, the value of the pull-up resistance should be:

$$R_{pull-up} = \frac{Trise}{3 \bullet Cload} \cong 3K\Omega \qquad (2)$$

Assuming that the voltage $V_{OUT}$ to be produced on the load capacitance is 10 V and that the unregulated boosted voltage output by the charge-pump circuit $V_{PUMP}$ is of 24V, the steady state current absorption from the charge-pump output node would be:

$$I_{SUNK22} = \frac{(24 - 10)V}{3K\Omega} \cong 5mA \qquad (3)$$

Clearly, a charge-pump circuit of such a large current capability would be unproposable in most cases, as for example in a compact large capacity nonvolatile memory device.

Description of preferred embodiments

In order to render current absorption independent from the load, a first embodiment of the invention is depicted in **Figure 3**, according to which, an output follower stage, FOLLOWER STAGE (HV), that is a high slew rate stage, is added, to act as a current buffer in charging the load capacitance $C_{LOAD}$ at the regulated boosted voltage $V_{OUT}$.

The follower stage is implemented with a high voltage NMOS transistor having its current terminals connected to the unregulated boosted voltage $V_{PUMP}$ and to the output node $V_{OUT}$, to which the resistive output voltage divider, $R_1$, $R_2$, of the feedback line $V_{FEED}$ is connected.

The advantage of this alternative embodiment is that at steady state, the current absorption of the output follower stage, $M_{NFOLL}$, will be of identical value to that of the prior art circuit of Figure 1, that is given by:

$$I_{SUNK3F} = I_{SUNK12} = \frac{V_{OUT}}{R_1 + R_2} \qquad (4)$$

Differently from the circuit of Figure 2, the capacitive load $C_{LOAD}$ is no longer charged to $V_{OUT}$ through the pull-up resistance $R_{PULL-UP}$, but through the output follower stage $M_{NFOLL}$, that is capable of delivering relatively high currents at charge transients. Indeed, the pull-up resistance $R_{PULL-UP}$, is completely untied from the load and may be freely dimensioned for reducing steady state absorption from the charge-pump generator. In any case, such a pull-up resistance must be capable of charging the gate of the output follower transistor in a sufficiently short time.

The difference from the circuit of Figure 2 is that according to this embodiment, the load represented by the capacitance of the gate of the follower stage transistor is many orders of magnitude less than the driven capacitance $C_{LOAD}$. Therefore, it is possible to employ a pull-up resistance in the order of hundreds KΩ.

For example, using a pull-up resistance of 200 KΩ, for a programmed $V_{OUT}$ of 10V, and assuming that between gate and source of the NMOS transistor $M_{NFOLL}$ of the follower stage there is a voltage drop of a threshold (about 1V), the current absorbed from the charge-pump output will be given by:

$$I = \frac{(24-11)V}{200K\Omega} \cong 65\mu A \qquad (5)$$

Such a current consumption of the regulating circuit is practically about the same of that of the first differential stage of the prior art regulator of Figure 1.

Of course, for higher output voltages, the current consumption of the regulating circuit will decrease.

Summarizing, when comparing the current absorption of the regulator of Figure 3 with that of the prior art circuit of Figure 1, the following remarks may be made:

- the output follower stage consumes as the output stage of the prior art circuit of Figure 1 ($I_{SUNK3F} = I_{SUNK32}$);
- the first stage of the regulator circuit of this invention, being supplied at $V_{DD}$, does not absorb current from the charge-pump;
- the second stage of the circuit of Figure 3, practically absorbs about the same current as the first differential stage of the prior art circuit of Figure 1 ($I_{SUNK32} \approx I_{SUNK11}$).

Therefore, according to the embodiment of Figure 3, the multistage regulating circuit of this invention does not have a current absorption from the charge-pump greater than the prior art circuit of Figure 1.

By simulating operation, the novel circuit according to the embodiment of Figure 3 has performances in terms of gain, cut off frequency, transients and PSRR, equal or better than the prior art circuit of Figure 1.

Of course, at it will be evident to a skilled person, the circuit of Figure 3 may be improved further in terms of maximum output voltage handling capability, by employing transistors formed in triple well (for eliminating the body effect on the follower stage) and natural transistors (for reducing the gate-source voltage drop of the follower stage.

## Claims

1. A multistage circuit for the regulation of the charge or of the discharge of a capacitance of an integrated device at a certain charge-pump generated boosted voltage comprising at least a first stage supplied at an unboosted power supply voltage ($V_{DD}$) of the integrated device and at least a second stage supplied at an unregulated charge-pump generated boosted voltage ($V_{PUMP}$), in cascade of the first stage,
   wherein
   said first stage includes a differential amplifier and said second stage has a resistive pull up ($R_{PULL-UP}$) and a high voltage transistor ($M_{NOUT}$), controlled by said differential amplifier, of P-type or of N-type depending on whether the sign of said boosted voltage is negative, or positive, respectively;
   **characterized by** an output follower stage coupled to the second stage, said output follower stage including another high voltage transistor ($M_{NFOLL}$) that is controlled by the second stage to charge the capacitance of the integrated circuit device, the another high voltage transistor of the output follower stage having its current terminals connected to the unregulated charge-pump generated boosted voltage ($V_{PUMP}$) and to an output node, to which a resistive output voltage divider is connected, the resistive output voltage divider being configured to provide a voltage ($V_{FEED}$), which is a scaled replica of an output voltage ($V_{OUT}$), to the first stage.

2. The multistage circuit for the regulation of the charge or of the discharge of a capacitance, according to claim 1, wherein the output follower stage is connected between the unregulated boosted voltage source and said capacitance.

3. The multistage circuit according to claim 1, wherein the output follower stage is connected between the unregulated boosted voltage source and said capacitance and controlled by an output of said second stage.

4. A multilevel flash memory device supplied at a certain power supply voltage and having a charge-pump circuit for programmably generating a boosted voltage of a certain value and a multistage circuit for the regulation of the charge or the discharge of a capacitance of an integrated device at said charge-pump generated boosted voltage, **characterized in that** said multistage regulating circuit is as defined in any of the preceding claims.

**5.** The multilevel flash memory device of claim 4, **characterized in that** it is of NAND type using positive power supply voltage and positive charge-pump generated boosted voltages and fabricated with a basic one-bit/cell process unsuitable to realize high voltage PMOS transistors.

**Patentansprüche**

**1.** Mehrstufige Schaltung zur Regelung der Ladung oder der Entladung einer Kapazität einer integrierten Vorrichtung bei einer bestimmten Ladungspumpen-erzeugten erhöhten Spannung, umfassend zumindest eine erste Stufe, die bei einer nicht erhöhten Versorgungsspannung ($V_{DD}$) der integrierten Vorrichtung gespeist wird, und zumindest eine zweite Stufe, die bei einer ungeregelten Ladungspumpen-erzeugten erhöhten Spannung ($V_{PUMP}$) gespeist wird, in Kaskade von der ersten Stufe,
wobei
die erste Stufe einen Differenzverstärker einschließt und die zweite Stufe eine ohmsche Pull-Up-Einrichtung ($R_{PULL-UP}$) und einen Hochspannungstransistor ($M_{NOUT}$), angesteuert vom Differenzverstärker, vom P-Typ oder vom N-Typ aufweist in Abhängigkeit davon, ob das Vorzeichen der erhöhten Spannung jeweils negativ oder positiv ist; **gekennzeichnet durch** eine an die zweite Stufe gekoppelte Ausgangsfolgerstufe, wobei die Ausgangsfolgerstufe einen weiteren Hochspannungstransistor ($M_{NFOLL}$) einschließt, der von der zweiten Stufe angesteuert wird, um die Kapazität der integrierten Schaltungsvorrichtung zu laden, wobei die Stromanschlüsse des weiteren Hochspannungstransistors der Ausgangsfolgerstufe mit der ungeregelten Ladungspumpen-erzeugten erhöhten Spannung ($V_{PUMP}$) und mit einem Ausgangsknoten verbunden sind, an den ein ohmscher Ausgangsspannungsteiler angeschlossen ist, wobei der ohmsche Ausgangsspannungsteiler so ausgelegt ist, dass er eine Spannung ($V_{FEED}$), die eine skalierte Replik einer Ausgangsspannung ($V_{OUT}$) ist, an die erste Stufe liefert.

**2.** Mehrstufige Schaltung zur Regelung der Ladung oder der Entladung einer Kapazität nach Anspruch 1, wobei die Ausgangsfolgerstufe zwischen der Quelle ungeregelter erhöhter Spannung und der Kapazität angeschlossen ist.

**3.** Mehrstufige Schaltung nach Anspruch 1, wobei die Ausgangsfolgerstufe zwischen der Quelle ungeregelter erhöhter Spannung und der Kapazität angeschlossen ist und von einem Ausgang der zweiten Stufe angesteuert wird.

**4.** Multi-Level-Flashspeichervorrichtung, gespeist bei einer bestimmten Versorgungsspannung und aufweisend eine Ladungspumpenschaltung zur programmierbaren Erzeugung einer erhöhten Spannung mit einem bestimmten Wert und eine mehrstufige Schaltung zur Regelung der Ladung oder der Entladung einer Kapazität einer integrierten Vorrichtung bei der Ladungspumpen-erzeugten erhöhten Spannung,
**dadurch gekennzeichnet, dass** die mehrstufige Regelschaltung so ist wie in einem der vorstehenden Ansprüche definiert.

**5.** Multi-Level-Flashspeichervorrichtung nach Anspruch 4, **dadurch gekennzeichnet, dass** sie vom NAND-Typ ist, der positive Versorgungsspannung und positive Ladungspumpen-erzeugte erhöhte Spannungen verwendet und hergestellt ist mit einem grundlegenden Ein-Bit/Zelle-Prozess, der sich nicht eignet, um Hochspannungs-PMOS-Transistoren auszuführen.

**Revendications**

**1.** Circuit à étages multiples pour la régulation de la charge ou de la décharge d'une capacitance d'un dispositif intégré à une certaine tension survoltée générée par une pompe de charge comprenant au moins un premier étage alimenté sous une tension d'alimentation non survoltée ($V_{DD}$) du dispositif intégré et au moins un deuxième étage alimenté sous une tension survoltée non régulée générée par une pompe de charge ($V_{PUMP}$), en cascade du premier étage dans lequel
ledit premier étage comprend un amplificateur différentiel et ledit deuxième étage présente une résistance de rappel à la source ($R_{PULL-UP}$) et un transistor haute-tension ($M_{NOUT}$), commandé par ledit amplificateur différentiel, du type P ou du type N en fonction du fait que le signe de ladite tension survoltée soit respectivement négatif ou positif ; **caractérisé par** un étage suiveur de sortie couplé au deuxième étage, ledit étage suiveur de sortie comportant un autre transistor haute tension ($M_{NFOLL}$) qui est commandé par le deuxième étage pour charger la capacitance du dispositif à circuit intégré, les bornes de l'autre transistor haute tension de l'étage suiveur de sortie étant connectées à la tension survoltée non régulée générée par pompe de charge ($V_{PUMP}$) et à un noeud de sortie auquel est connecté un diviseur de tension de sortie à résistance, le diviseur de tension de sortie à résistance étant configuré pour fournir une tension ($V_{FEED}$), qui est une réplique à l'échelle d'une tension de sortie ($V_{OUT}$), au premier étage.

**2.** Circuit à étages multiples pour la régulation de la charge ou de la décharge d'une capacitance, selon la revendication 1, dans lequel l'étage suiveur de sortie est connecté entre la source de tension survoltée non régulée et ladite capacitance.

**3.** Circuit à étages multiples selon la revendication 1, dans lequel l'étage suiveur de sortie est connecté entre la source de tension survoltée non régulée et ladite capacitance et est commandé par une sortie dudit deuxième étage.

**4.** Dispositif à mémoire flash à niveaux multiples alimenté à une certaine tension d'alimentation et présentant un circuit de pompe de charge destiné à générer de façon programmable une tension survoltée d'une certaine valeur et un circuit à étages multiples destiné à réguler la charge ou la décharge d'une capacitance d'un dispositif intégré, à ladite tension survoltée générée par une pompe de charge, **caractérisé en ce que** ledit circuit de régulation à étages multiples répond à la définition de l'une quelconque des revendications précédentes.

**5.** Dispositif à mémoire flash à niveaux multiples selon la revendication 4, **caractérisé en ce qu'**il est du type NON-ET et utilise une tension d'alimentation positive et des tensions survoltées positives générées par une pompe de charge, en étant de fabrication mettant en oeuvre un procédé de base d'un bit par cellule non approprié à la réalisation de transistors PMOS haute tension.

FIRST STAGE (HV)          SECOND STAGE (HV)

$V_{PUMP}$      $V_{PUMP}$

$M_{P1}$          $M_{P2}$

$V_{PUMP}$

$M_{POUT}$

OUTFSTG

$C_M$

$M_{N1}$      $M_{N2}$      $V_{REF}$

$V_{OUT}$

$C_{LOAD}$

$M_{NT1}$      $V_{BIAS}$

$I_{SUNKJ1}$

$R_2$

$I_{SUNKJ2}$

$V_{FEED}$

$R_1$

FIG. 1

**FIG. 2**

**FIG. 3**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 2002118568 A
- US 6347029 B1